# EUROPEAN PATENT SPECIFICATION

(11) **EP 3 001 465 B1**
(45) Date of publication and mention of the grant of the patent: **12.06.2019**
(21) Application number: 14801832.8
(22) Date of filing: 08.04.2014
(51) Int. Cl.: H01L 33/32, H01L 33/00, H01L 33/14

(54) **LIGHT-EMITTING ELEMENT AND METHOD FOR PREPARING SAME**
LICHTEMITTIERENDES ELEMENT UND VERFAHREN DESSEN HERSTELLUNG
ELÉMENT ÉLECTROLUMINESCENT ET SON PROCÉDÉ DE PRÉPARATION

(30) Priority: 22.05.2013 KR 20130057847
(43) Date of publication of application: 30.03.2016
(73) Proprietor: Seoul Viosys Co., Ltd., Danwon-gu Ansan-si, Gyeonggi-do 425-851 (KR)
(72) Inventor: AN, Soon Ho, Ansan-si Gyeonggi-do 425-851 (KR); HAN, Chang Suk, Ansan-si 425-851 Gyeonggi-do (KR); YUN, Jun Ho, Ansan-si 425-851 Gyeonggi-do (KR); KIM, Chae Hon, Ansan-si 425-851 Gyeonggi-do (KR); LYU, Si Hoon, Ansan-si 00000 Gyeonggi-do (KR)
(74) Representative: Isarpatent
(86) International application number: PCT/KR2014/003032
(87) International publication number: WO 2014/189207

(56) References cited:
- EP-A2- 2 017 900
- JP-A- 2013 012 683
- KR-A- 20100 068 107
- KR-A- 20100 068 107
- KR-B1- 100 838 196
- US-A1- 2008 315 212
- US-A1- 2009 065 762
- US-A1- 2012 107 991
- US-B1- 6 287 947

## Description

### [Technical Field]

The present invention relates to a nitride semiconductor light emitting device, and more particularly to a nitride semiconductor light emitting device including a p-type semiconductor layer and a method for fabricating the same.

### [Background Art]

Generally, a nitride semiconductor light emitting device includes an n-type semiconductor layer, an active layer and a p-type semiconductor layer. In the active layer, electrons and holes are recombined to emit light. The recombination rate of electrons and holes in the active layer directly affects luminous efficacy of the light emitting device. In order to enhance the recombination rate of electrons and holes in the active layer, the light emitting device is required to prevent overflow of electrons and an electron blocking layer of a p-type AlGaN layer is employed for this purpose.

On the other hand, there is a method of controlling a doping profile in the p-type semiconductor layer in order to improve injection efficiency of holes from the active layer into the p-type semiconductor layer. For example, a patent document (Korean Patent Registration No. 10-0838196) discloses improvement in hole injection efficiency by dividing a hole injection layer and a p-type contact layer in which the hole injection layer has a lower dopant concentration than the p-type contact layer. In addition, this document discloses a structure in which an undoped layer is disposed between a clad layer and the hole injection layer or between the hole injection layer and the p-type contact layer.

According to this patent document, mobility of holes in the hole injection layer is increased to promote movement of holes to be injected into the active layer. However, according to the patent document, the hole injection layer is doped in a relatively low concentration, thereby restricting improvement in hole mobility.

Moreover, although the patent document discloses the undoped layer not doped with Mg, the undoped layer is grown substantially under the same conditions of source gas and carrier gas as the hole injection layer and the p-type contact layer except for an Mg source gas. In this case, even though the Mg source gas is not supplied, the undoped layer has a relatively high concentration of Mg, thereby reducing hole mobility. KR 2010 0068107 A relates to a semiconductor light emitting device comprising a first electrical conductive semiconductor layer, an active layer, and a second conductive type structure wherein an active layer is formed on the first electrical conductive semiconductor layer. EP 2 017 900 A2 relates to a light emitting diode comprising an N-type semiconductor layer, a P-type semiconductor layer and an active layer interposed between the N-type and P-type semiconductor layers. US 2008/315212 A1 relates to a a method for fabricating a group III-V p-type nitride structure. US 2009/065762 A1 relates to a light emitting diode for minimizing crystal defects in an active region and enhancing recombination efficiency of electrons and holes in the active region includes non-polar GaN-based semiconductor layers grown on a non-polar substrate.

### [Disclosure]

### [Technical Problem]

The invention is defined in the appended claims. Disclosed is a light emitting device capable of improving efficiency in hole injection into an active layer, and a method of fabricating the same.

Disclosed is a method of growing a p-type semiconductor layer capable of reducing dopant concentration of an undoped layer in the p-type semiconductor layer, and a method of fabricating a light emitting device.

### [Technical Solution]

Disclosed is a light emitting device includes an n-type semiconductor layer; a p-type semiconductor layer; an active layer disposed between the n-type semiconductor layer and the p-type semiconductor layer; and an electron blocking layer disposed between the p-type semiconductor layer and the active layer. The p-type semiconductor layer includes a stack structure in which a low concentration doping layer, an undoped layer and a high concentration doping layer are sequentially stacked one above another, and a thickness of the undoped layer is greater than the sum of thicknesses of the low concentration doping layer and the high concentration doping layer.

A relatively thick undoped layer is disposed between the low concentration doping layer and the high concentration doping layer to increase hole mobility, thereby improving hole injection efficiency.

The low concentration doping layer has a dopant concentration of 1E20/cm³ to 5E20/cm³, the high concentration doping layer may have a dopant concentration of 5E20/cm³ to 1E21/cm³, and the undoped layer may have a dopant concentration of less than 2E19/cm³. In addition, the undoped layer may have a dopant concentration of 1F19/cm³ to less than 2E19/cm³ depending on depth thereof.

With the structure wherein the undoped layer having a dopant concentration of less than 2E19/cm³ is disposed between the low concentration doping layer having a dopant concentration of 1E20/cm³ or more and the high concentration doping layer having a dopant concentration of 5E20/cm³ or more, the light emitting device has further improved hole mobility.

The low concentration doping layer may contact the electron blocking layer. With the structure wherein the doping layer is disposed to contact the electron blocking layer, the light emitting device enables easy injection of holes into the active layer through the electron blocking layer. The high concentration doping layer may be a p-type contact layer, thereby reducing contact resistance.

The light emitting device may be a light emitting diode chip and may be a vertical type or lateral type light emitting device, without being limited thereto.

In accordance with another aspect of the present invention, a method of growing a p-type semiconductor layer via metal organic chemical vapor deposition is provided. The method of growing a p-type semiconductor layer includes growing a low concentration doping layer on a substrate within a chamber by supplying a nitrogen source gas, a gallium source gas, an Mg source gas, N₂ gas and H₂ gas into the chamber; growing an undoped layer on the low concentration doping layer by supplying a nitrogen source gas, a gallium source gas and N₂ gas into the chamber while blocking supply of the Mg source gas and the H₂ gas; and growing a high concentration doping layer on the undoped layer by supplying a nitrogen source gas, a gallium source gas, an Mg source gas, N₂ gas and H₂ gas into the chamber.

During growth of the low concentration doping layer and the high concentration doping layer, the H₂ gas is supplied into the chamber, thereby improving crystal quality of semiconductor layers, and during growth of the undoped layer, supply of the H₂ is blocked, thereby decreasing the dopant concentration within the undoped layer.

The method of growing a p-type semiconductor layer may further include changing an atmosphere of the chamber into a nitrogen and NH₃ atmosphere by supplying a nitrogen source gas and N₂ gas into the chamber while blocking supply of the gallium source gas, the Mg source gas and the H₂ gas before growth of the low concentration doping layer. This process enables sufficient removal of H₂ gas from the chamber. Change of the atmosphere within the chamber to the nitrogen and NH₃ atmosphere may takes 3 to 10 minutes.

During growth of the low concentration doping layer and the high concentration doping layer, a flow rate of the H₂ gas may be higher than the flow rate of the N₂ gas. During growth of the low concentration doping layer and the high concentration doping layer, the flow rate of the H₂ gas may be three to five times the flow rate of the N₂ gas.

During growth of the low concentration doping layer and the high concentration doping layer, a flow rate of the NH₃ gas may be less than the flow rate of the H₂ gas, and during growth of the undoped layer, the flow rate of the N₂ gas may be higher than the flow rate of the NH₃ gas.

For example, during growth of the low concentration doping layer and the high concentration doping layer, a flow rate ratio of N₂, H₂ and NH₃ may be about 1:3:1, and during growth of the undoped layer, the flow rate of N₂, H₂ and NH₃ may be about 3:0:1.

During growth of the low concentration doping layer and the high concentration doping layer, the H₂ gas may be predominantly supplied, thereby improving crystal quality of semiconductor layers grown on the substrate, and during growth of the undoped layer, the flow rate of the N₂ gas may be increased while blocking supply of H₂, thereby allowing an overall pressure within the chamber to be kept constant.

Growth temperatures may decrease in the order of the low concentration doping layer, the undoped layer and the high concentration doping layer.

The low concentration doping layer may have a dopant concentration of 1E20/cm³ to 5E20/cm³, the high concentration doping layer may have a dopant concentration of 5E20/cm³ to 1E21/cm³, and the undoped layer may have a dopant concentration of less than 2E19/cm³.

After growth of the high concentration doping layer, the p-type semiconductor layer may be subjected to heat treatment within the chamber. Accordingly, dopants within the p-type semiconductor layer can be activated.

In accordance with a further aspect of the present invention, a method of fabricating a light emitting device is provided. The method of fabricating a light emitting device includes growing an n-type semiconductor layer, an active layer, an electron blocking layer, and a p-type semiconductor layer on a substrate by metal organic chemical vapor deposition. Here, the p-type semiconductor layer may be grown by the method of growing a p-type semiconductor layer as set forth above and may be grown on the electron blocking layer.

The invention is defined by the claims.

### [Advantageous Effects]

According to exemplary embodiments, a relatively thick undoped layer is disposed between a low concentration doping layer and a high concentration doping layer to increase hole mobility, thereby improving hole injection efficiency of the light emitting device. Furthermore, during growth of the undoped layer, supply of H₂ gas is blocked to further reduce a dopant concentration within the undoped layer, thereby further increasing hole mobility within the undoped layer.

### [Description of Drawings]

Figure 1 is a schematic sectional view of a light emitting device according to one exemplary embodiment of the present invention.
Figure 2 is a schematic diagram depicting gas and temperature profiles for illustrating a method of growing a p-type semiconductor layer according to one exemplary embodiment of the present invention.

### [Mode for Invention]

Hereinafter, exemplary embodiments of the present invention will be described in detail with reference to the accompanying drawings. The following embodiments are given by way of illustration to provide a thorough understanding of the disclosure to those skilled in the art. Accordingly, the present invention is not limited to the embodiments disclosed herein and may also be implemented in different forms. In the drawings, widths, lengths, thicknesses, and the like of elements may be exaggerated for clarity and descriptive purposes. Throughout the specification, like components having the same or similar functions will be denoted by like reference numerals.

Figure 1 is a schematic sectional view of a light emitting device according to one exemplary embodiment of the present invention.

Referring to Figure 1, the light emitting device may include a substrate 21, buffer layer 23, an n-type semiconductor layer 25, a superlattice layer 27, an active layer 29, an electron blocking layer 31, and a p-type semiconductor layer 33.

The substrate 21 may be, for example, a patterned sapphire substrate, a spinel substrate, a silicon carbide substrate, or a gallium nitride substrate, without being limited thereto.

The buffer layer 23 may include a low temperature buffer layer and a high temperature buffer layer. When the substrate 21 is a gallium nitride, the buffer layer 23 may be omitted.

The n-type semiconductor layer 25 includes an n-type contact layer. The n-type semiconductor layer 25 may be formed of an (Al, Ga, In)N-based Group III nitride semiconductor material and may be composed of a single layer or multiple layers. For example, the n-type semiconductor layer 25 includes a GaN layer and may be formed by doping n-type dopants, for example, Si.

The superlattice layer 27 may be adopted to improve current spreading and crystal quality of the active layer. The superlattice layer 27 may be formed by repeatedly stacking, for example, GaN/InGaN or InGaN/InGaN layers.

The active layer 27 is disposed between the n-type semiconductor layer 25 and the p-type semiconductor layer 33 and may have a single quantum well structure having a single well layer or a multi-quantum well structure wherein well layers and barrier layers are alternately stacked one above another. The well layers may be formed of, for example, InGaN, and the barrier layers may be formed of a gallium nitride semiconductor, for example, GaN, which has a wider band gap than the well layers.

The electron blocking layer 31 is disposed between the active layer 29 and the p-type semiconductor layer 33, and prevents overflow of electrons from the active layer 29 to the p-type semiconductor layer 33. The electron blocking layer 31 may be formed of a gallium nitride semiconductor, for example, AlGaN, which typically has a wider band gap than the p-type semiconductor layer 33.

The p-type semiconductor layer 33 includes a low concentration doping layer 33a, an undoped layer 33b, and a high concentration doping layer 33c. The low concentration doping layer 33a, the undoped layer 33b and the high concentration doping layer 33c may be formed of gallium nitride semiconductor materials, for example, GaN, which have the same composition except for dopant concentration. Accordingly, when supplied from an electrode (not shown), holes can pass through the p-type semiconductor layer 33 without an energy barrier. The low concentration doping layer 33a may be disposed to contact the electron blocking layer 31. Further, the high concentration doping layer 33c may be a p-type contact layer which contacts the electrode (not shown).

A thickness of the undoped layer 33b may be greater than the sum of thicknesses of the low concentration doping layer 33a and the high concentration doping layer 33c. For example, the low concentration doping layer 33a may have a thickness of 5 nm to 20 nm, the undoped layer 33b may have a thickness of 60 nm to 110 nm, and the high concentration doping layer 33c may have a thickness of 10 nm to 30 nm.

The low concentration doping layer 33a may have a dopant concentration of 1F20/cm³ to 5E20/cm³, the high concentration doping layer 33c may have a dopant concentration of 5E20/cm³ to 1F21/cm³, and the undoped layer 33b may have a dopant concentration of less than 2E19/cm³. In addition, the undoped layer 33b may have a dopant concentration of 1F19/cm³ to less than 2E19/cm³ depending on depth thereof.

As the undoped layer 33b is formed to a relatively high thickness and the dopant concentration is lowered, the light emitting device has significantly increased hole mobility, thereby improving efficiency in hole injection into the active layer 29.

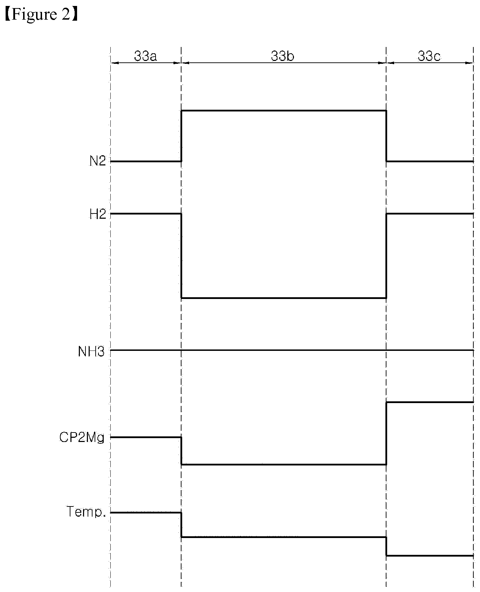

Figure 2 is a schematic diagram depicting gas and temperature profiles for illustrating a method of growing the p-type semiconductor layer according to the exemplary embodiment. Herein, the p-type semiconductor layer 33 is grown by metal organic chemical vapor deposition, and the buffer layer 23, the n-type semiconductor layer 25, the superlattice layer 27, the active layer 29 and the electron blocking layer 31 may also be grown in-situ within the same chamber by metal organic chemical vapor deposition.

Referring to Figures 1 and 2, with a substrate loaded within a chamber, a metal source gas, a nitrogen source gas and a carrier gas or an atmosphere gas are supplied into the chamber to grow semiconductor layers such as the buffer layer 23, the n-type semiconductor layer 25, the superlattice layer 27, the active layer 29, and the electron blocking layer 31. A source gas of n-type dopants may be supplied into the chamber as needed.

The metal source gas includes a Ga source gas, an Al source gas and/or an In source gas, and a suitable source gas depending upon a metal component of a gallium nitride semiconductor layer to be grown is supplied. For example, generally, TMGa or TEGa may be used as the Ga source gas, TMAl or TEAl may be used as the Al source gas, and TMIn or TEIn may be used as the In source gas.

On the other hand, NH₃ may be generally used as a nitrogen (N) source gas, and SiH₄ may be used as the source gas of n-type dopants. In addition, N₂ and/or H₂ may be generally used as the carrier gas or the atmosphere gas.

After growth of the electron blocking layer 31, the p-type semiconductor layer 33 is grown within the chamber by metal organic chemical vapor deposition. The p-type semiconductor layer 33 may be grown at a pressure of 100 Torr to 300 Torr.

First, the low concentration doping layer 33a is grown on the electron blocking layer 31 at a temperature of, for example, 970°C to 990°C. The low concentration doping layer 33a may be grown by supplying an Mg source gas (for example, Cp2Mg), N₂ gas and H₂ gas together with a nitrogen source gas (for example, NH₃) and a gallium source gas (for example, TMGa or TEGa) into the chamber. At this point, the N₂ gas is supplied at a flow rate of about 30 to 50 L/min, the H₂ gas may be supplied at a flow rate of 140 to 160 L/min, the NH₃ gas may be supplied at a flow rate of 30 to 50 L/min. For example, the flow rate ratio of N₂:H₂:NH₃ may be 1:3:1. On the other hand, the flow rate of the Mg source gas may be determined to achieve a suitable doping concentration, and the low concentration doping layer 33a may have an Mg doping concentration of about 1F20/cm³ to 5E20/cm³.

After growth of the low concentration doping layer 33a, the undoped layer 33b is grown at a temperature of, for example, 940°C to 970°C. The undoped layer 33b is grown by supplying a nitrogen source gas (for example, NH₃), a gallium source gas (for example, TMGa or TEGa) and N₂ gas into the chamber while blocking supply of the Mg source gas and the H₂ gas. For example, the N₂ source gas may be supplied at a flow rate of 140 to 160 L/min, the H₂ source gas may be supplied at a flow rate of 0 L/min, and the NH₃ gas may be supplied at a flow rate of 30 to 50 L/min. Particularly, the flow rate ratio of N₂:H₂:NH₃ may be 3:0:1.

Generally, even in the case where the Mg source gas is not supplied, Mg is supplied from the low concentration doping layer 33a to the undoped layer 33b during growth of the undoped layer 33b. The inventors of the invention found that supply of H₂ gas during growth of the undoped layer 33b accelerated supply of Mg. Accordingly, it is possible to reduce the dopant concentration within the undoped layer 33b by blocking supply of H₂ during growth of the undoped layer 33b.

The dopant concentration of the undoped layer 33b can be influenced by the doping concentration of the low concentration doping layer 33a and the high concentration doping layer 33c, and the undoped layer 33b may have a doping concentration of less than 2E19/cm³ within the doping concentration of the low concentration doping layer 33a and the high concentration doping layer 33b described herein. Furthermore, the dopant concentration of the undoped layer 33b may range from 1F19/cm³ to less than 2E19/cm³ depending on depth thereof. Such a doping concentration is difficult to achieve by a typical method of growing a p-type semiconductor layer in which H₂ gas is supplied during growth of the undoped layer.

On the other hand, the atmosphere of the chamber may be changed to a nitrogen and NH₃ atmosphere before growth of the undoped layer 33b. To this end, before growth of the low concentration doping layer 33b, a nitrogen source gas and N₂ gas may be supplied into the chamber while blocking supply of a gallium source gas, an Mg source gas and the H₂ gas. Change of the atmosphere within the chamber into the nitrogen and NH₃ atmosphere may be carried out for about 3 to 10 minutes.

After growth of the low concentration doping layer 33b, the high concentration doping layer 33c may be grown at a temperature of, for example, 910°C to 940°C. The high concentration doping layer 33c is grown on the undoped layer 33b by supplying a nitrogen source gas (for example, NH₃), a gallium source gas (for example, TMGa or TEGa), an Mg source gas (for example, Cp2Mg), N₂ gas and H₂ gas into the chamber. For example, the N₂ gas may be supplied at a flow rate of 30 to 50 L/min, the H₂ gas may be supplied at a flow rate of 140 to 160 L/min, and the NH₃ gas may be supplied at a flow rate of 30 to 50 L/min. For example, the flow rate ratio of N₂:H₂:NH₃ may be 1:3:1, and the high concentration doping layer 33c may be grown under the same conditions as the low concentration doping layer 33b except for the flow rate of the Mg source gas. On the other hand, the flow rate of the Mg source gas may be determined to achieve a suitable doping concentration and the low concentration doping layer 33a may have an Mg doping concentration of about 5E20/cm³ to 1E21/cm³.

After growth of the high concentration doping layer 33c, the temperature of the chamber is decreased to about 700°C to 800°C and the p-type semiconductor layer 33 is subjected to heat treatment in a N₂ atmosphere.

According to this embodiment, the dopant concentration of the undoped layer 33b can be decreased by blocking supply of H₂ gas during growth of the undoped layer 33b. Furthermore, during growth of the low concentration doping layer 33a and the high concentration doping layer 33c, N₂ gas and H₂ gas may be supplied, thereby preventing deterioration in crystal quality of the p-type semiconductor layer 33.

Then, electrodes are formed to contact the n-type semiconductor layer 25 and the p-type semiconductor layer 33, respectively, followed by dicing the stack structure of the semiconductor layers into individual light emitting diode chips, thereby providing lateral type or flip-chip type light emitting devices. In some exemplary embodiments, a support substrate (not shown) may be formed on an upper surface of the p-type semiconductor layer 33 and the substrate 21 may be removed, thereby providing a light emitting device, for example, a vertical type light emitting diode chip, from which the growth substrate is removed.

### (Experimental Example)

In order to confirm light output and an Mg doping profile depending upon supply of H₂ gas during growth of the undoped layer 33b, light emitting diode chips was fabricated by changing the flow rate ratio of N₂:H₂:NH₃ during growth of the undoped layer 33b. Here, during growth of the undoped layer 33b, a reference flow rate ratio of N₂:H₂:NH₃ was set to 1:3:1 and a comparative flow rate ratio was set to 3:0:1 under the same pressure condition.

As a measurement result of light output of the light emitting diode chips, the light emitting diode chip fabricated by blocking supply of H₂ during growth of the undoped layer 33b had about 10% higher light output than the reference sample.

On the other hand, the Mg doping profiles of the samples fabricated in the experimental example were subjected to SIMS analysis under the same conditions. For the reference sample, a significant Mg doping concentration of about 3E19/cm³ or more was observed in the undoped layer 33b near the boundary between the low concentration doping layer 33a and the undoped layer 33b, and it was also observed that the Mg doping concentration exhibited a tendency of gradually increasing from the boundary between the high concentration doping layer 33c and the undoped layer 33b to the boundary between the low concentration doping layer 33a and the undoped layer 33b, and the Mg doping concentration in the undoped layer 33b was in the range of about 8E18/cm³ to about 3E19/cm³ depending upon the depth thereof.

On the contrary, in the light emitting diode chip fabricated by blocking supply of H₂ gas during growth of the undoped layer 33b, an Mg doping concentration of less than 2E19/cm³ was observed in the undoped layer 33b near the boundary between the low concentration doping layer 33a and the undoped layer 33b, and it was also observed that the Mg doping concentration exhibited a tendency of gradually increasing from the boundary between the high concentration doping layer 33c and the undoped layer 33b to the boundary between the low concentration doping layer 33a and the undoped layer 33b. The Mg doping concentration in the undoped layer 33b was in the range of 1E19/cm³ to less than 2E19/cm³ depending upon the length thereof.

Accordingly, it can be seen that the introduction of Mg from the low concentration doping layer 33a to the undoped layer 33b can be suppressed by blocking supply of H₂ gas during growth of the undoped layer 33b, thereby decreasing the Mg doping concentration in the undoped layer 33b. Furthermore, it is anticipated that reduction of the Mg doping concentration in the undoped layer 33b will improve hole mobility, thereby improving light output through improvement in hole injection efficiency.

### FURTHER, THE APPLICATION DESCRIBES THE FOLLOWING EMBODIMENTS:

Embodiment 1: A method of growing a p-type semiconductor layer using metal organic chemical vapor deposition, comprising:
growing a low concentration doping layer on a substrate within a chamber by supplying a nitrogen source gas, a gallium source gas, an Mg source gas, N₂ gas and H₂ gas into the chamber;
growing an undoped layer on the low concentration doping layer by supplying a nitrogen source gas, a gallium source gas and N₂ gas into the chamber while blocking supply of the Mg source gas and the H₂ gas; and
growing a high concentration doping layer on the undoped layer by supplying a nitrogen source gas, a gallium source gas, an Mg source gas, N₂ gas and H₂ gas into the chamber.

Embodiment 2: The method of embodiment 1, further comprising:
before growth of the low concentration doping layer, changing an atmosphere of the chamber into a nitrogen and NH₃ atmosphere by supplying a nitrogen source gas and N₂ gas into the chamber while blocking supply of the gallium source gas, the Mg source gas and the H₂ gas.

Embodiment 3: The method of embodiment 1, wherein a flow rate of the H₂ gas is higher than the flow rate of the N₂ gas during growth of the low concentration doping layer and the high concentration doping layer.

Embodiment 4: The method of embodiment 3, wherein the flow rate of the H₂ gas is three to five times the flow rate of the N₂ gas during growth of the low concentration doping layer and the high concentration doping layer.

Embodiment 5: The method of embodiment 4, wherein a flow rate of the NH₃ gas is less than the flow rate of the H₂ gas during growth of the low concentration doping layer and the high concentration doping layer, and the flow rate of the N₂ gas is higher than the flow rate of the NH₃ gas during growth of the undoped layer.

## Claims

1. A light emitting device comprising:
an n-type semiconductor layer (25);
a p-type semiconductor layer (33);
an active layer (29) disposed between the n-type semiconductor layer (25) and the p-type semiconductor layer (33); and
an electron blocking layer (31) disposed between the p-type semiconductor layer (33) and the active layer (29),
wherein the p-type semiconductor layer (33) includes a stack structure in which a low concentration doping layer (33a), an undoped layer (33b) and a high concentration doping layer (33c) are sequentially stacked one above another,
**characterized in that**
a thickness of the undoped layer (33b) is greater than the sum of thicknesses of the low concentration doping layer (33a) and the high concentration doping layer (33c), and that the low concentration doping layer (33a) has a dopant concentration of 1E20/cm³ to 5E20/cm³, the high concentration doping layer (33c) has a dopant concentration of 5E20/cm³ to 1E21/cm³, and the undoped layer (33b) has a dopant concentration of less than 2E19/cm³.

2. The light emitting device of claim 1, wherein the low concentration doping layer (33a) contacts the electron blocking layer (31), and the high concentration doping layer (33c) is a p-type contact layer.

3. The light emitting device of claim 1, wherein the light emitting device is a lateral type, flip-chip type or vertical type light emitting diode chip.

4. A method of fabricating a light emitting device, comprising:
growing an n-type semiconductor layer (25), an active layer (29), an electron blocking layer (31), and a p-type semiconductor layer (33) on a substrate (21) by metal organic chemical vapor deposition,
wherein the growing the p-type semiconductor layer (33) includes:
growing a low concentration doping layer (33a) on the electron blocking layer (31) by supplying a nitrogen source gas, a gallium source gas, an Mg source gas, N₂ gas and H₂ gas into the chamber;
growing an undoped layer (33b) on the low concentration doping layer (33a) by supplying a nitrogen source gas, a gallium source gas and N₂ gas into the chamber while blocking supply of the Mg source gas and the H₂ gas; and
growing a high concentration doping layer (33c) on the undoped layer (33b) by supplying a nitrogen source gas, a gallium source gas, an Mg source gas, N₂ gas and H₂ gas into the chamber,
**characterized in that**
the low concentration doping layer (33a) has a dopant concentration of 1E20/cm³ to 5E20/cm³, the high concentration doping layer (33c) has a dopant concentration of 5E20/cm³ to 1E21/cm³, and the undoped layer (33b) has a dopant concentration of less than 2E19/cm³.

5. The method of claim 4, wherein growth temperatures decrease in the order of the low concentration doping layer (33a), the undoped layer (33b) and the high concentration doping layer (33c).

6. The method of claim 4, further comprising:
before growth of the low concentration doping layer (33a), changing an atmosphere of the chamber into a nitrogen and NH₃ atmosphere by supplying a nitrogen source gas and N₂ gas into the chamber while blocking supply of the gallium source gas, the Mg source gas and the H₂ gas.

7. The method of claim 6, wherein a time for changing the atmosphere of the chamber into the nitrogen and NH₃ atmosphere is 3 to 10 minutes.

8. The method of claim 4, wherein a flow rate of the H₂ gas is higher than the flow rate of the N₂ gas during growth of the low concentration doping layer (33a) and the high concentration doping layer (33c).

9. The method of claim 8, wherein the flow rate of the H₂ gas is three to five times the flow rate of the N₂ gas during growth of the low concentration doping layer (33a) and the high concentration doping layer (33c).

10. The method of claim 9, wherein a flow rate of the NH₃ gas is less than the flow rate of the H₂ gas during growth of the low concentration doping layer (33a) and the high concentration doping layer (33c), and the flow rate of the N₂ gas is higher than the flow rate of the NH₃ gas during growth of the undoped layer (33b).

11. The method of claim 10, wherein a flow rate ratio of N₂, H₂ and NH₃ is 1:3:1 during growth of the low concentration doping layer (33a) and the high concentration doping layer (33c), and the flow rate of N₂, H₂ and NH₃ is 3:0:1 during growth of the undoped layer (33b).

12. The method of claim 4, further comprising:
after growth of the high concentration doping layer (33c), heat-treating the p-type semiconductor layer (33) within the chamber.

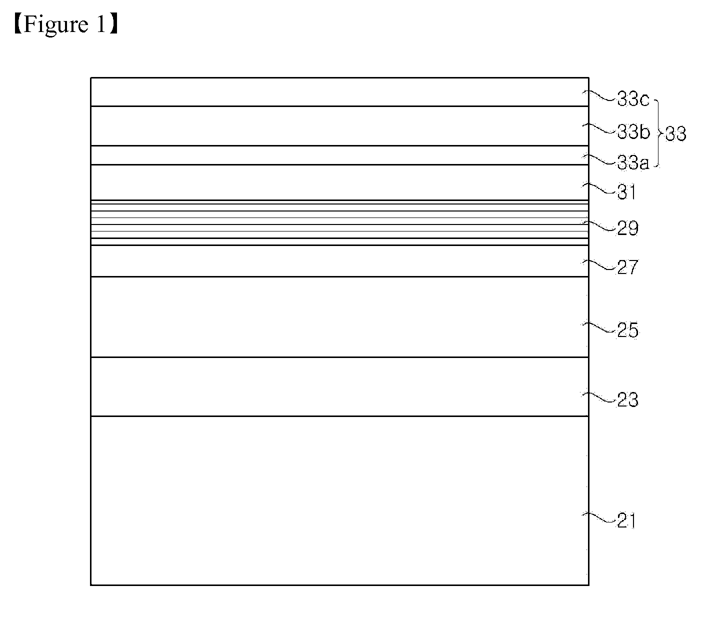

## Patentansprüche

1. Leuchtvorrichtung, die Folgendes umfasst:
eine Halbleiterschicht (25) vom n-Typ;
einen Halbleiterschicht (33) vom p-Typ;
eine aktive Schicht (29), die zwischen der Halbleiterschicht (25) vom n-Typ und der Halbleiterschicht (33) vom p-Typ angeordnet ist; und
eine Elektronensperrschicht (31), die zwischen der Halbleiterschicht (33) vom p-Typ und der aktiven Schicht (29) angeordnet ist,
wobei die Halbleiterschicht (33) vom p-Typ eine Stapelstruktur enthält, in der eine schwach-konzentrierte Dotierungsschicht (33a), eine undotierte Schicht (33b) und eine stark-konzentrierte Dotierungsschicht (33c) der Reihe nach übereinander gestapelt sind,
**dadurch gekennzeichnet, dass**
eine Dicke der undotierten Schicht (33b) größer ist als die Summe von Dicken der schwach-konzentrierten Dotierungsschicht (33a) und der stark-konzentrierten Dotierungsschicht (33c), und dass die schwach-konzentrierte Dotierungsschicht (33a) eine Dotandenkonzentration von 1E20/cm³ bis 5E20/cm³ hat, die stark-konzentrierte Dotierungsschicht (33c) eine Dotandenkonzentration von 5E20/cm³ bis 1E21/cm³ hat, und die undotierte Schicht (33b) eine Dotandenkonzentration von weniger als 2E19/cm³ hat.

2. Leuchtvorrichtung nach Anspruch 1, wobei die schwach-konzentrierte Dotierungsschicht (33a) die Elektronensperrschicht (31) berührt, und die stark-konzentrierte Dotierungsschicht (33c) eine Kontaktschicht vom p-Typ ist.

3. Leuchtvorrichtung nach Anspruch 1, wobei die Leuchtvorrichtung ein Leuchtdiodenchip vom lateralen Typ, vom Flipchip-Typ oder vom vertikalen Typ ist.

4. Verfahren zum Herstellen einer Leuchtvorrichtung, die Folgendes umfasst:
Züchten einer Halbleiterschicht (25) vom n-Typ, einer aktiven Schicht (29), einer Elektronensperrschicht (31), und einer Halbleiterschicht (33) vom p-Typ auf einem Substrat (21) durch metallorganische chemische Aufdampfung, wobei das Züchten der Halbleiterschicht (33) vom p-Typ Folgendes enthält:
Züchten einer schwach-konzentrierten Dotierungsschicht (33a) auf der Elektronensperrschicht (31) durch Einleiten eines Stickstoffquellengases, eines Galliumquellengases, eines Mg-Quellengases, eines N₂-Gases und eines H₂-Gases in die Kammer;
Züchten einer undotierten Schicht (33b) auf der schwach-konzentrierten Dotierungsschicht (33a) durch Einleiten eines Stickstoffquellengases, eines Galliumquellengases und eines N₂-Gases in die Kammer, während die Zufuhr des Mg-Quellengases und des H₂-Gases gesperrt wird; und
Züchten einer stark-konzentrierten Dotierungsschicht (33c) auf der undotierten Schicht (33b) durch Einleiten eines Stickstoffquellengases, eines Galliumquellengases, eines Mg-Quellengases, eines N2-Gases und eines H₂-Gases in die Kammer,
**dadurch gekennzeichnet, dass**
die schwach-konzentrierte Dotierungsschicht (33a) eine Dotandenkonzentration von 1E20/cm³ bis 5E20/cm³ hat, die stark-konzentrierte Dotierungsschicht (33c) eine Dotandenkonzentration von 5E20/cm³ bis 1E21/cm³ hat, und die undotierte Schicht (33b) eine Dotandenkonzentration von weniger als 2E19/cm³ hat.

5. Verfahren nach Anspruch 4, wobei die Wachstumstemperaturen in der Reihefolge der schwach-konzentrierten Dotierungsschicht (33a), der undotierten Schicht (33b) und der stark-konzentrierte Dotierungsschicht (33c) abnehmen.

6. Verfahren nach Anspruch 4, das des Weiteren Folgendes umfasst:
vor dem Züchten der schwach-konzentrierten Dotierungsschicht (33a), Ändern einer Atmosphäre der Kammer zu einer Stickstoff- und NH₃-Atmosphäre durch Einleiten eines Stickstoffquellengases und eines N₂-Gases in die Kammer, während die Zufuhr des Galliumquellengases, des Mg-Quellengases und des H₂-Gases gesperrt wird.

7. Verfahren nach Anspruch 6, wobei eine Zeitdauer zum Ändern der Atmosphäre der Kammer zu der Stickstoff- und NH₃-Atmosphäre 3 bis 10 Minuten beträgt.

8. Verfahren nach Anspruch 4, wobei eine Strömungsrate des H₂-Gases höher ist als die Strömungsrate des N₂-Gases während des Züchtens der schwach-konzentrierten Dotierungsschicht (33a) und der stark-konzentrierten Dotierungsschicht (33c).

9. Verfahren nach Anspruch 8, wobei die Strömungsrate des H₂-Gases drei- bis fünfmal höher ist als die Strömungsrate des N₂-Gases während des Züchtens der schwach-konzentrierten Dotierungsschicht (33a) und der stark-konzentrierten Dotierungsschicht (33c).

10. Verfahren nach Anspruch 9, wobei eine Strömungsrate des NH₃-Gases niedriger ist als die Strömungsrate des H₂-Gases während des Züchtens der schwach-konzentrierten Dotierungsschicht (33a) und der stark-konzentrierten Dotierungsschicht (33c), und die Strömungsrate des N₂-Gases höher ist als die Strömungsrate des NH₃-Gases während des Züchtens der undotierten Schicht (33b).

11. Verfahren nach Anspruch 10, wobei ein Strömungsratenverhältnis von N₂, H₂ und NH₃ 1:3:1 während des Züchtens der schwach-konzentrierten Dotierungsschicht (33a) und der stark-konzentrierten Dotierungsschicht (33c) beträgt, und die Strömungsrate von N₂, H₂ und NH₃ 3:0:1 während des Züchtens der undotierten Schicht (33b) beträgt.

12. Verfahren nach Anspruch 4, das des Weiteren Folgendes umfasst:
nach dem Züchten der stark-konzentrierten Dotierungsschicht (33c), Wärmebehandeln der Halbleiterschicht (33) vom p-Typ in der Kammer.

## Revendications

1. Dispositif d'émission de lumière comprenant :
une couche semi-conductrice de type n (25) ;
une couche semi-conductrice de type p (33) ;
une couche active (29) disposée entre la couche semi-conductrice de type n (25) et la couche semi-conductrice de type p (33) ; et
une couche de blocage des électrons (31) disposée entre la couche semi-conductrice de type p (33) et la couche active (29),
dans lequel la couche semi-conductrice de type p (33) comprend une structure d'empilement dans laquelle une couche de dopage à basse concentration (33a), une couche non dopée (33b) et une couche de dopage à haute concentration (33c) sont empilées en séquence les unes sur les autres,
**caractérisé en ce que**
une épaisseur de la couche non dopée (33b) est supérieure à la somme des épaisseurs de la couche de dopage à basse concentration (33a) et de la couche de dopage à haute concentration (33c), et **en ce que** la couche de dopage à basse concentration (33a) a une concentration en dopant de 1E20/cm³ à 5E20/cm³, la couche de dopage à haute concentration (33c) a une concentration en dopant de 5E20/cm³ à 1E21/cm³, et la couche non dopée (33b) a une concentration en dopant inférieure à 2E19/cm³.

2. Dispositif d'émission de lumière selon la revendication 1, dans lequel la couche de dopage à basse concentration (33a) est en contact avec la couche de blocage des électrons (31), et la couche de dopage à haute concentration (33c) est une couche de contact de type p.

3. Dispositif d'émission de lumière selon la revendication 1, dans lequel le dispositif d'émission de la lumière est une puce à diode électroluminescente de type latéral, de type à puce retournée ou de type vertical.

4. Procédé de fabrication d'un dispositif d'émission de lumière, comprenant les étapes consistant à :
faire croître une couche semi-conductrice de type n (25), une couche active (29), une couche de blocage des électrons (31) et une couche semi-conductrice de type p (33) sur un substrat (21) par dépôt en phase vapeur par procédé chimique organométallique,
dans lequel la croissance de la couche semi-conductrice de type p (33) comprend les étapes consistant à :
faire croître une couche de dopage à basse concentration (33a) sur la couche de blocage des électrons (31) en fournissant un gaz source d'azote, un gaz source de gallium, un gaz source de Mg, du gaz N₂ et du gaz H₂ dans la chambre ;
faire croître une couche non dopée (33b) sur la couche de dopage à basse concentration (33a) en fournissant un gaz source d'azote, un gaz source de gallium et du gaz N₂ dans la chambre tout en bloquant l'alimentation en gaz source de Mg et en gaz H₂ ; et
faire croître une couche de dopage à haute concentration (33a) sur la couche non dopée (33b) en fournissant un gaz source d'azote, un gaz source de gallium, un gaz source de Mg, du gaz N₂ et du gaz H₂ dans la chambre, **caractérisé en ce que**
la couche de dopage à basse concentration (33a) a une concentration en dopant de 1E20/cm³ à 5E20/cm³, la couche de dopage à haute concentration (33c) a une concentration en dopant de 5E20/cm³ à 1E21/cm³, et la couche non dopée (33b) a une concentration en dopant inférieure à 2E19/cm³.

5. Procédé selon la revendication 4, dans lequel les températures de croissance diminuent dans l'ordre de la couche de dopage à basse concentration (33a), à la couche non dopée (33b) et à la couche de dopage à haute concentration (33c).

6. Procédé selon la revendication 4, comprenant en outre l'étape consistant à :
avant la croissance de la couche de dopage à basse concentration (33a), changer une atmosphère de la chambre en azote et NH₃ en fournissant un gaz source d'azote et de gaz N₂ dans la chambre tout en bloquant la fourniture de gaz source de gallium, de gaz source de Mg et de gaz H₂.

7. Procédé selon la revendication 6, dans lequel un temps pour changer l'atmosphère de la chambre en une atmosphère d'azote et de NH₃ est de 3 à 10 minutes.

8. Procédé selon la revendication 4, dans lequel un débit du gaz H₂ est supérieur au débit du gaz N₂ lors de la croissance de la couche de dopage à basse concentration (33a) et de la couche de dopage à haute concentration (33c).

9. Procédé selon la revendication 8, dans lequel un débit du gaz H₂ est de trois à cinq fois le débit du gaz N₂ lors de la croissance de la couche de dopage à basse concentration (33a) et de la couche de dopage à haute concentration (33c).

10. Procédé selon la revendication 9, dans lequel un débit du gaz NH₃ est inférieur au débit du gaz H₂ pendant la croissance de la couche de dopage à basse concentration (33a) et de la couche de dopage à haute concentration (33c), et le débit du gaz N₂ est supérieur au débit du gaz NH₃ pendant la croissance de la couche non dopée (33b).

11. Procédé selon la revendication 10, dans lequel un rapport des débits de N₂, H₂ et NH₃ est égal à 1:3:1 pendant la croissance de la couche de dopage à basse concentration (33a) et de la couche de dopage à haute concentration (33c), et le rapport des débits de N₂, H₂ et NH₃ est égal à 3:0:1 pendant la croissance de la couche non dopée (33b).

12. Procédé selon la revendication 4, comprenant en outre l'étape consistant à :
après la croissance de la couche de dopage à haute concentration (33c), effectuer un traitement thermique sur la couche semi-conductrice de type p (33) dans la chambre.
